# EUROPÄISCHE PATENTSCHRIFT

(11) **EP 2 379 989 B1**
(45) Veröffentlichungstag und Bekanntmachung des Hinweises auf die Patenterteilung: **04.09.2019**
(21) Anmeldenummer: 09801409.5
(22) Anmeldetag: 18.12.2009
(51) Int. Cl.: G01D 21/00, G01D 4/00, H01L 31/02, H04W 84/18

(54) **PHOTOVOLTAIK-ANLAGE MIT MODULÜBERWACHUNG**
PHOTOVOLTAIC SYSTEM HAVING MODULE MONITORING
INSTALLATION PHOTOVOLTAÏQUE COMPRENANT UNE SURVEILLANCE DES MODULES

(30) Priorität: 16.01.2009 DE 102009005327; 19.06.2009 DE 102009029934
(43) Veröffentlichungstag der Anmeldung: 26.10.2011
(73) Patentinhaber: Phoenix Contact GmbH & Co. KG, 32825 Blomberg (DE)
(72) Erfinder: KALHOFF, Johannes, 32825 Blomberg (DE); TEMME, Thorsten, 30459 Hannover (DE); BENT, Roland, 32758 Detmold (DE)
(74) Vertreter: Blumbach · Zinngrebe Patentanwälte PartG mbB
(86) Internationale Anmeldenummer: PCT/EP2009/009136
(87) Internationale Veröffentlichungsnummer: WO 2010/081524

(56) Entgegenhaltungen:
- WO-A1-2007/132473
- WO-A1-2008/012041
- DE-U1-202008 010 312
- VENKATACHALAM L ET AL: "Wireless Sensor Networks to Characterize Photovoltaic Panels in Harsh Environmental Conditions", SIGNAL PROCESSING AND COMMUNICATIONS, 2007. ICSPC 2007. IEEE INTERNATIONAL CONFERENCE ON, IEEE, PISCATAWAY, NJ, USA, 24 November 2007 (2007-11-24), pages 788-791, XP031380641, ISBN: 978-1-4244-1235-8

## Beschreibung

### Gebiet der Erfindung

Die Erfindung betrifft eine Photovoltaik-Anlage mit einer Überwachung der Photovoltaik-Module, bei welchem die Photovoltaik-Module einzeln mit einem Kommunikationsnetzwerk vernetzt sind, um die Photovoltaik-Module modulspezifisch zu überwachen.

### Hintergrund der Erfindung

In einer typischen Photovoltaik-Anlage (im Folgenden wird "Photovoltaik", wie in der Fachwelt üblich, mit "PV" abgekürzt) werden mehrere PV-Module zu einem PV-Strang in Reihe geschaltet, um so eine für die DC-AC-Wandlung und anschließende Netzeinspeisung geeignete Gleichspannung von einigen 100 bis 1000 Volt, zukünftig eventuell auch bis 1500 Volt, zu erreichen. Der PV-Strang wird entweder direkt an einen PV-Wechselrichter angeschlossen (Strang-Wechselrichter), oder mehrere Stränge, die möglichst den gleichen Aufbau haben und gleichen Einstrahlbedingungen ausgesetzt sind, werden parallel geschaltet und an einen zentralen Wechselrichter (Zentralwechselrichter) angeschlossen. Zur Reduzierung des Verdrahtungsaufwandes kann die Parallelschaltung von mehreren Strängen zu einem PV-Teilgenerator (auch PV-Array genannt) in einem PV-Teilgenerator-Anschlusskasten (auch PV-Array-Box oder PV-String-Combiner genannt) erfolgen. Diese wiederum können dann in PV-Generator-Anschlusskästen zusammengefasst werden, die letztendlich an einen Zentralwechselrichter angeschlossen werden, so dass sich eine Baumstruktur in der Leistungs-Verdrahtung ergibt.

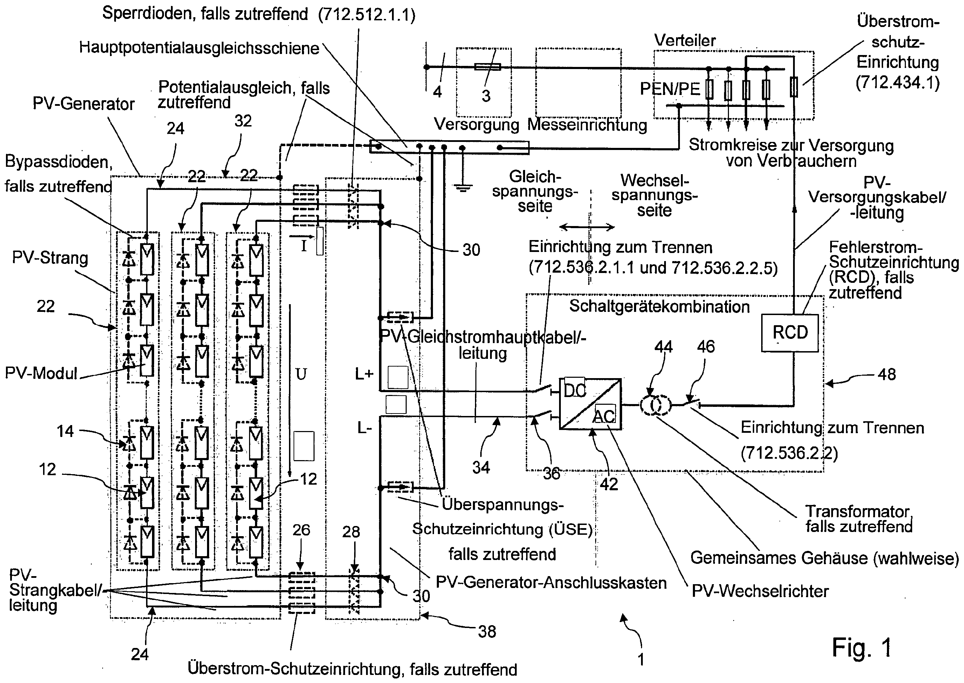

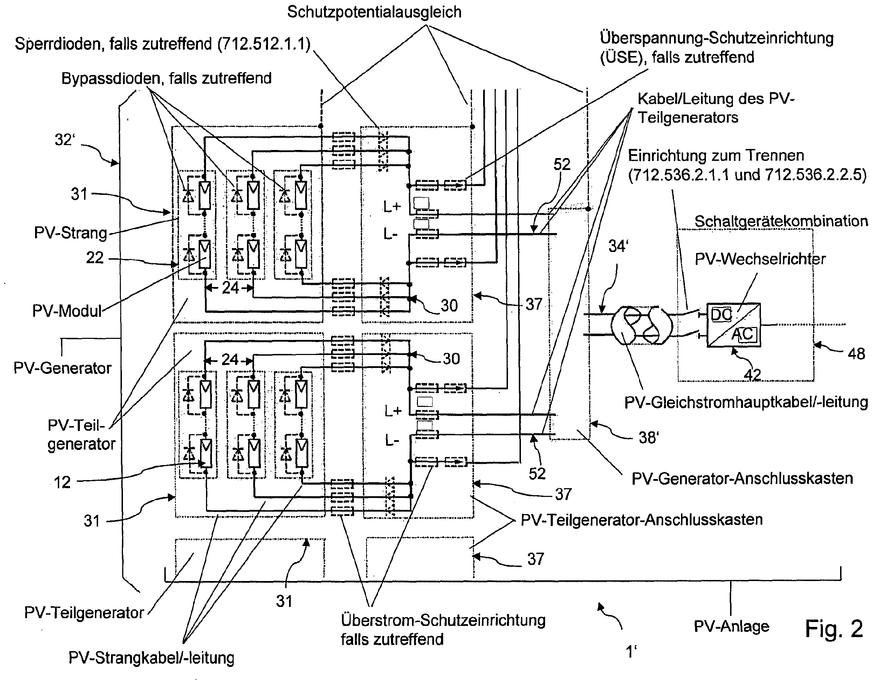

Fig. 1 zeigt eine PV-Anlage in Form eines Ein-PV-Stromversorgungssystems nach DIN VDE 0100-712 (VDE 0100-712): 2006-06, Bild 712.1. Hierbei handelt es sich um eine PV-Anlage mit nur einem PV-Generator. Fig. 2 zeigt eine PV-Anlage nach DIN VDE 0100-712 (VDE 0100-712): 2006-06, Bild 712.2 mit mehreren PV-Teilgeneratoren. Der Aufbau wird nachfolgend in der detaillierten Beschreibung noch näher erläutert, wobei der grundsätzliche Aufbau dem Fachmann bekannt ist. Die in dieser Anmeldung verwendete Terminologie entspricht der DIN VDE 0100-712 (VDE 0100-712): 2006-06, welche dem Fachmann bekannt ist, die aber der Vollständigkeit halber hiermit durch Referenz zum Gegenstand der vorliegenden Offenbarung gemacht wird.

Mit zunehmender Verschaltung der PV-Anlage nehmen die Möglichkeiten ab, die Betriebsdaten von Teilbereichen der PV-Anlage von einem stromaufwärts gelegenen Teil in der vorstehend genannten Baumstruktur selektiv zu erfassen und zu analysieren und gegebenenfalls Maßnahmen zur Wartung oder Optimierung zu ergreifen.

Eine Möglichkeit zur Anlagenüberwachung ist die Integration von Sensorik in dem PV-Teilgenerator-Anschlusskasten (auch String-Combiner-Box). Hierbei werden zum einen die Spannung zwischen den für jeden Strang gleichen Plus- und Minuspol und selektiv die Ströme der einzelnen Stränge gemessen. Somit können die abgegebenen Leistungen der einzelnen Stränge verglichen werden, die Messwerte repräsentieren in diesem Fall den Durchschnittswert des übergeordneten Stranges oder generell des dem Messpunkt übergeordneten Anlagenteils und erlauben allenfalls eingeschränkt den Vergleich einzelner Module in der Baumstruktur. Leitungsunterbrechungen und Totalausfälle einzelner Module lassen sich zum Teil noch detektieren, stellen sich jedoch Leistungsabfälle in mehreren Modulen ein, die unterschiedlichen Strängen zugeordnet werden, zum Beispiel durch Teilverschattungen über mehrere Stränge oder vorzeitige Alterung einzelner Module, so nimmt die Möglichkeit einer Fehlerdetektion ab, da adäquate Vergleichswerte fehlen. Abgleiche der Strangleistungen über Referenzstellen können hier nur eingeschränkt Abhilfe schaffen, da diese nicht den gleichen Umgebungsbedingungen, wie z. B. Temperatur oder Wind ausgesetzt werden können.

Aus der DE 40 32 569 C2 ist es bekannt, jedes Modul mit einem integrierten Wechselrichter mit MPP-Tracking auszustatten. Ein MPP-Tracker regelt typischerweise die Spannung auf denjenigen Wert, bei dem das System bei maximaler Leistung arbeitet (Maximum Power Point, MPP). Hierzu variiert der MPP-Tracker den entnommenen Strom um einen kleinen Betrag, errechnet die Leistung und stellt den Stromwert in Richtung höherer Leistung nach. Mittels einer Steuereinheit werden Signale an einen Datenbus gegeben, der diese Daten dem Leistungs- und Steuerteil zum Überprüfen der Funktionsfähigkeit des Moduls zuführt. Nachteilig bei dieser Anlage ist der Aufwand für die Vielzahl an Wechselrichtern mit MPP-Trackern sowie die starre Struktur der Datenübertragung.

Aus der DE 102 22 621 A1 ist ein Solargenerator mit einem variablen Strombypass bekannt, welcher derart gesteuert wird, dass jeder Generator kontinuierlich in seinem jeweils aktuellen, spezifischen MPP betrieben wird. Eine komplexe Anlagenüberwachung ist hiermit nicht möglich.

Aus der DE 20 2007 011 806 U1 ist ein Solarelementesystem mit Identchips bekannt, in welchem ein für jedes Solarelement individueller Identcode gespeichert ist. Die Identchips der Solarelemente sind über einen Zwei-Draht-Parallel-Bus und eine Interface-Schaltung mit einem Zentralprozessor verbunden. Der Zentralprozessor weist einen Prozessorspeicher auf, in welchem alle Identcodes des Solarelementesystems gespeichert sind. Die Daten werden mit Identifikationsnummer übertragen. Nachteilig hierbei ist wiederum die starre Struktur der Datenübertragung sowie die Notwendigkeit der Individualisierung der Solarelemente.

Aus der DE 20 2005 020 161 U1 ist eine Vorrichtung zur Überwachung von Photovoltaik-Paneelen bekannt, bei welcher im Generatoranschlusskasten eine Restspannung bei Dunkelheit erfasst wird und die Messwerte einem Fensterkomperator zugeführt werden. Bei dem Wechselrichter ist eine zentrale Alarmeinrichtung mit Dekodierer vorgesehen, um einen paneelbezogenen Alarm auszulösen, wenn eine bestimmte Signalschwelle unterschritten wird.

Weiter ist aus der DE 198 59 732 A1 die Übertragung von Informationen vom Wechselrichter zu einer Zentrale im Zeitmultiplexverfahren mit der Energieübertragung über die Netzleitung beschrieben. Nachteiligerweise ist hierzu eine Netztrennung notwendig, wenn die Daten übertragen werden sollen.

Aus der WO 2008/012041 geht die Übertragung von Solarmodulinformationen an eine zentrale Steuerung hervor. Nachteilig ist dem System, dass zur Installation der Photovoltaikanlage eine manuelle Zuordnung von Solarmodul zu Sendeeinrichtung zu erfolgen hat.

Aus der WO 2007/132473 A1 geht ein automatisiertes Verbrauchszählerauslesesystem hervor welches ein ad-hoc vermaschtes Netzwerk umfasst, um Daten mit einer Kontrollstation auszutauschen.

Aus VENKATACHALAM L ET AL: "Wireless Sensor Networks to Characterize Photovoltaic Panels in Harsh Environmental Conditions",SIGNAL PROCESSING AND COMMUNICATIONS, 2007. ICSPC 2007. IEEE INTERNATIONAL CONFERENCE ON, IEEE, PISCATAWAY, NJ, USA, 24. November 2007 (2007-11-24), Seiten 788-791, XP031380641,ISBN: 978-1-4244-1235-8 geht das Senden von Daten von PV-Module mittels eines Funk-Netzwerks hervor.

Nachteilig bei den genannten Systemen ist jeweils die starre Struktur der Datenübertragung, die geringe Flexibilität sowie gegebenenfalls Störungsanfälligkeit, insbesondere bei sehr großen PV-Anlagen.

### Allgemeine Beschreibung der Erfindung

Es ist daher eine Aufgabe der vorliegenden Erfindung, eine PV-Anlage bereitszustellen, welche eine flexible, störungsunanfällige und vielseitige Überwachung jedes einzelnen PV-Moduls erlaubt, wobei die einzelnen PV-Module herstellungsseitig ununterscheidbar sein können.

Eine weitere Aufgabe der Erfindung ist es, eine PV-Anlage bereitzustellen, welche einfach und unkompliziert durch einen Monteur aufzubauen und anzuschließen ist, wobei der Monteur jedes PV-Modul an jeder beliebigen Position des PV-Generators einbauen kann, ohne eine bestimmte Netzwerkstruktur oder Identifikation der PV-Module berücksichtigen zu müssen.

Noch eine Aufgabe der Erfindung ist es, eine PV-Anlage bereitszustellen, welche frühzeitig Ausfall, Abhandenkommen und/oder Verschattung einzelner PV-Module erfasst und positionsbezogene Daten hierzu verfügbar macht.

Die Aufgabe der Erfindung wird durch den Gegenstand der unbahängigen Patentansprüche gelöst. Die Unteransprüche betreffen Weiterbildungen der Erfindung.

Erfindungsgemäß wird eine Photovoltaik-Anlage, kurz PV-Anlage mit einer Vielzahl von PV-Modulen bereitgestellt. Jedes PV-Modul umfasst wiederum eine Vielzahl von zwischen zwei Außenanschlüssen, den sogenannten Ribbons, die aus der sonnenabgewandten Rückseite des PV-Moduls herausragen, verbundenen Solarzellen. Die Außenanschlüsse jedes PV-Moduls werden mit jeweils einer sogenannten Anschluss- und Verbindungsdose, welche auf der Rückseite des jeweiligen PV-Moduls befestigt ist, elektrisch kontaktiert. Die PV-Module sind also beim Aufbau der PV-Anlage vor Ort die kleinsten handhabbaren Einheiten des PV-Generators. Jedes PV-Modul wird mit einer sogenannten Anschluss- und Verbindungsdose elektrisch kontaktiert, um den von dem PV-Modul erzeugten Strom abzuführen.

Die PV-Module sind in Bezug auf die Stromleitungen, wie vorstehend erläutert, in einer Baumstruktur strukturiert. Die PV-Anlage umfasst hierzu einen oder mehrere PV-Generatoren, wobei in letzterem Fall diese auch als PV-Teilgeneratoren bezeichnet werden. Jeder PV-Generator oder PV-Teilgenerator umfasst eine Mehrzahl von parallel geschalteten PV-Strängen, welche wiederum eine Mehrzahl an in Serie geschalteten PV-Modulen umfassen.

Die PV-Module sind demnach mittels PV-Stromverbindungsleitungen oder PV-Strangleitungen seriell zu PV-Strängen verbunden, wobei über die PV-Stromverbindungsleitungen bzw. PV-Strangleitungen der von den PV-Modulen bzw. PV-Strängen erzeugte elektrische Strom geleitet wird. Die PV-Stränge wiederum sind parallel zu dem PV-Generator oder PV-Teilgenerator zusammengeschaltet.

Die PV-Anlage umfasst weiter einen oder mehrere PV-Wechselrichter zur Umwandlung des von den PV-Modulen erzeugten Gleichstroms in einen netztauglichen Wechselstrom, zur Einspeisung ggf. nach Umtransformation in das öffentliche Stromnetz.

Jedes PV-Modul weist ferner ggf. eine Messeinrichtung zur Erfassung von zumindest einer momentanen Leistungskenngröße, z.B. Status, Spannung, Strom, Leistung des jeweiligen PV-Moduls auf, so dass individuell für jedes PV-Modul die Leistungskenngröße, vorzugsweise gleichstromseitig, erfasst werden kann.

Z.B. können aus der Summe der Modulleistungen je Strang oder in der gesamten Anlage und einem Abgleich mit den an einem oder mehreren Invertern anliegenden DC-Leistung Schäden in der Leistungsverkabelung sowie Installationsfehler bei der Leistungsverkabelung der Module erkannt werden.

Weiter weist jedes PV-Modul jeweils eine eigene Kommunikations-Schnittstelle auf, um die PV-Module auf PV-Modul-Ebene zu einem Kommunikations-Netzwerk zu verbinden. Die PV-Module der PV-Anlage sind also untereinander in dem Kommunikations-Netzwerk verbunden. Somit bildet jedes PV-Modul einen Netzknoten des Kommunikations-Netzwerkes. Über das Kommunikations-Netzwerk werden von jedem PV-Modul nun Kommunikations-Nachrichten mit modulspezifischen Daten, z.B. über die zumindest eine momentane Leistungskenngröße des jeweiligen PV-Moduls an eine Kontrolleinrichtung oder Auswerteeinrichtung übertragen. Die Kontrolleinrichtung ist vorzugsweise mit einem Netzwerkkoordinator verbunden. Durch die Datenerfassung und Datenübertragung auf PV-Modul-Ebene, d.h. separat von jedem PV-Modul an die Kontrolleinrichtung kann diese die zumindest eine Leistungskenngröße jedes einzelnen PV-Moduls modulspezifisch auswerten. Es können weiter Diagnosedaten aus den Messwerten ermittelt werden, so dass die Funktion jedes einzelnen PV-Moduls zentral überprüft werden kann.

Dadurch dass ggf. die Erfassung relevanter Leistungskenngrößen (z.B. Status, Leistung, Spannung oder Strom) auf jedem einzelnen PV-Modul erfolgt und Daten bzw. die Messwerte über das Kommunikations-Netzwerk übertragen werden, kann z.B. die Leistungsabgabe jedes einzelnen PV-Moduls ausgewertet werden. Ferner können die Leistungskenngrößen der einzelnen PV-Module untereinander verglichen werden. Hierdurch ist es möglich, die Energieerzeugungskosten eines Solarkraftwerkes zu reduzieren und die sogenannte "Performance Ratio" solcher Anlagen zu erhöhen. Hierzu wird die Performance Ratio PR = E_{AC} / Eₛₒₗ ^{∗} η_{mod} bestimmt und optimiert, wobei E_{AC} die ins Netz eingespeiste Energie (AC), Eₛₒₗ die eingestrahlte Solarenergie und η_{mod} der PV-Modul-Wirkungsgrad ist. Eine Analyse des Solarkraftwerkes auf PV-Modulebene ermöglicht es, i) Fehler frühzeitig zu erkennen, ii) Fehler genauer zu identifizieren, iii) Fehler genauer zu lokalisieren, iv) Wartung frühzeitig zu planen und damit v) Ausfallzeiten zu reduzieren.

Als besonders vorteilhaft hat sich erwiesen, das Kommunikations-Netzwerk als ein selbstorganisierendes Netzwerk - ohne vorher festgelegte Zuordnungen der Kommunikationspfade - auszubilden, bei welchem sich also die PV-Module selbstständig mit anderen, typischerweise benachbarten, PV-Modulen vernetzen. Demnach erfolgt die Koordinierung der Kommunikation auf dem Netzwerk in selbstorganisierender Form. Das selbstorganisierende Kommunikations-Netzwerk benötigt keine vorher festgelegten Zuordnungen der Kommunikationspfade, z.B. zwischen dem Netzwerkkoordinator und einem bestimmten PV-Modul. Das selbstorganisierende Kommunikations-Netzwerk kommt also ohne fixe Netzwerk-Infrastruktur aus. Insbesondere erfolgt die Koordinierung des Kanalzugriffs und die Synchronisation der Netzknoten untereinander in selbstorganisierender Form. Es wird z.B. die Netzwerk-Adresse der PV-Module in selbstorganisierender Form von dem Kommunikations-Netzwerk vergeben. Die Kommunikationsmodule müssen als solche (herstellungsseitig) somit nicht identifizierbar sein, was ggf. vorteilhaft für die Massenproduktion der PV-Module ist.

Das selbstorganisierende Kommunikations-Netzwerk bleibt auch bei einem Ausfall eines oder einiger Netzknoten voll funktionsfähig, da sich jeder Netzknoten, d.h. jedes PV-Modul selbstständig mit einem oder mehreren Netzknoten seiner Nachbarschaft vernetzt. In vorteilhafter Weise kann das Kommunikations-Netzwerk dadurch den Ausfall eines oder einiger Netzknotens automatisch kompensieren. Das Kommunikations-Netzwerk passt sich dann selbstorganisiert an den Ausfall einzelner Netzknoten oder PV-Module an und leitet die Kommunikation automatisch über andere Netzknoten um.

Besonders vorteilhaft bei einem derartigen selbstorganisierenden Kommunikations-Netzwerk ist, trotz Einzelüberwachung auf PV-Modulebene, dass der Aufwand für die Netzwerkinstallation relativ gering gehalten werden kann. Es ist z.B. nicht zwingend notwendig, jedes PV-Modul mit einem Wechselrichter auszustatten, wenngleich dies nicht ausgeschlossen ist. Es kann jedenfalls, falls dies erwünscht ist, mit einem oder mehreren Zentralwechselrichtern gearbeitet werden. Ferner ist die Installation einfach und eine aufwändige Initialisierung kann ggf. vermieden werden. Daher können die Installationskosten für das Kommunikation-Netzwerk trotz der großen Anzahl (ggf. > 100, > 1000 oder gar > 10.000) von PV-Modulen und damit Netzwerkknoten, in vertretbarem Rahmen gehalten werden. Ein weiterer Vorteil der PV-Anlage mit selbstorganisierendem Kommunikations-Netzwerks ist dessen Robustheit gegen äussere Störungen. Es kann sogar den Totalausfall einzelner oder einiger Netzknoten verkraften, was insbesondere bei großen Solarkraftwerken vorteilhaft sein kann.

Gemäß der Erfindung ist das Kommunikations-Netzwerk unabhängig von den PV-Stromverbindungsleitungen für die photovoltaisch erzeugte Leistung. Dadurch kann sich die Topologie des Kommunikations-Netzwerks grundlegend von der Topologie der PV-Stromverbindungsleitungen unterscheiden. Letztere ist aufgrund der Anforderungen an Peak-Spannung und Peak-Strom der PV-Stränge und PV-Teilgeneratoren typischerweise vorab planerisch festgelegt. Dadurch wird eine flexible Topologie des Kommunikation-Netzwerks ermöglicht. Dies kann sowohl für drahtgebundene als auch für drahtlose Kommunikations-Netzwerke grundsätzlich vorteilhaft sein. Aufgrund der Sebstorganisation des Kommunikations-Netzwerks existiert keine vordefinierte feste Struktur des Kommunikations-Netzwerks, die der Monteur beim Einbau der PV-Module beachten müsste. Der Monteur kann die PV-Module also gemäß dem vorgegebenen Plan der Leistungsverkabelung (PV-Stromverbindungsleitungen und/oder PV-Strangleitungen) montieren und die Leistungsverkabelung zwischen den PV-Modulen verbinden und zwar ohne Rücksicht auf irgendeine Struktur des Kommunikationsnetzwerks nehmen zu müssen, d.h. unabhängig vom Kommunikations-Netzwerk. Wenn sich dann nach der Montage und dem Zusammenstecken der Leistungsverkabelung das Kommunikations-Netzwerk selbst organisiert hat, kann über das Kommunikations-Netzwerk durch einen Vergleich zwischen einer vorberechneten Soll-Leistung mit der Ist-Leistung bei bekannten Sonneneinstrahlbedingungen sogar überprüft werden, ob die Leistungsverkabelung durch den Monteur richtig ausgeführt wurde.

Aktive und passive Netzwerkknoten können kombiniert werden.

Besonders bevorzugt ist es, das selbstorganisierende Netzwerk als Funk-Netzwerk auszubilden. Das Funk-Netzwerk ist insbesondere als vermaschtes Netzwerk ausgebildet (Mesh Netzwerk). Bei dem vermaschten Netzwerk ist die Vielzahl der PV-Module untereinander in einer Maschenstruktur vernetzt. Dabei werden die Daten von PV-Modul zu PV-Modul weitergereicht, bis sie die Kontrolleinrichtung erreicht haben. Das vermaschte Kommunikations-Netzwerk findet seinen Kommunikationsfluss somit automatisch und dynamisch über die gesamte PV-Anlage. Dabei werden bei dem vermaschten Netzwerk die Kommunikationswege nicht durch einen festen Aufbau/Planung vorgegeben, sondern finden sich selbst und können auch bei einer Störung bereits vorhandener Wege neue Wege finden. Bei einem vermaschten Funk-Netzwerk kann daher der Ausfall von einzelnen Kommunikationswegen oder Funkstrecken durch Umorganisation der Kommunikationpfade zwischen den einzelnen PV-Modulen kompensiert werden. Vorzugsweise ist das Kommunikations-Netzwerk demnach als dynamisches, selbstorganisierendes, dezentral gesteuertes Funk-System ausgebildet. Für die erfindungsgemäße PV-Anlage sind z.B. drahtlose Übertragungssysteme nach IEEE 802.15.4, TSMP (Time Synchronized Meshed Protocol), ZigBee oder Wireless Hart geeignet. Auch GSM oder GPRS Systeme aus dem Telekommunikationsumfeld können hier, eingeschränkt z.B. auf dezentrale Informationsknotenpunkte (z.B. mit unterlagertem Mesh Netzwerk), Verwendung finden. Ggf. sind einige der Netzwerkknoten so ausgestattet, dass sie auch im spannungslosen Zustand durch ein externes Funkkommando angesprochen werden können, diese sind z.B. in der PV-Array-Box integriert. Es können auch mehrere Mesh-Netzwerk in einem Cluster vorgesehen sein und jedes Mesh-Netzwerk des Clusters als Teil des Backbones genutzt werden.

Gemäß einer bevorzugten Ausführungsform ermöglicht das Kommunikations-Netzwerk eine automatische Ortung der jeweiligen PV-Module in der PV-Anlage. Z.B. weist das vermaschte Funk-Netzwerk Mittel zur Entfernungsmessung zwischen den Netzknoten bzw. PV-Modulen auf, so dass jeweils die tatsächliche Entfernung zwischen den PV-Modulen messbar ist und die gemessenen Entfernungsdaten über das Funk-Netzwerk an die Kontrolleinrichtung übermittelt werden können. Wenn ein fest vorgegebener Bezugspunkt vorhanden ist, wird bevorzugt zusätzlich eine Entfernungsmessung zwischen zumindest einem der Netzknoten und dem fest vorgegebenen Bezugspunkt durchgeführt. Die Kontrolleinrichtung erstellt dann mittels der empfangenen Entfernungsdaten eine Ist-Positionskarte der tatsächlichen PV-Module in dem Netzwerk, insbesondere mit den in selbstorganisierender Form vergebenen Adressen der jeweiligen PV-Module. Die zumindest eine erfasste Leistungskenngröße jedes PV-Moduls kann somit von der Kontrolleinrichtung zur ermittelten Ist-Position des jeweiligen PV-Moduls zugeordnet werden, so dass eine örtliche Zuordnung der zumindest einen Leistungskenngröße für jedes PV-Modul in dem PV-Generator erfolgt. Somit kann das Kommunikations-Netzwerk feststellen, an welcher Stelle des PV-Generators ein PV-Modul z.B. verschattet, ausgefallen oder abhanden gekommen ist, insbesondere ohne dass die PV-Module von vorne herein identifizierbar sein müssen.

Vorzugsweise ermittelt die PV-Anlage bzw. die Kontrolleinrichtung, insbesondere mittels der Entfernungsmessung, eine Ist-Positionskarte der tatsächlichen Positionen der PV-Module und gleicht die Ist-Positionskarte mit einem Modell-Layout ab. Hierzu umfasst die PV-Anlage bzw. die Kontrolleinrichtung einen Speicher mit dem gespeicherten Modell-Layout der örtlichen Soll-Positionen aller FV-Module in dem PV-Generator. Die PV-Anlage bzw. die Kontrolleinrichtung kann die zumindest eine jeweils erfasste Leistungskenngröße der tatsächlichen PV-Module dann jeweils einer PV-Modulposition in dem Modell-Layout zuordnen. Dieser Layout-Abgleich wird auch als "Einrasten" der Ist-Positionskarte auf das Modell-Layout bezeichnet. Hierdurch kann noch genauer bestimmt werden, welches PV-Modul ggf. verschattet, ausgefallen, abhanden gekommen oder anderweitig gestört ist. Weiter vorzugsweise wird hierzu ein Referenz-PV-Modul festgelegt, welches als Referenzpunkt beim Einrasten der Ist-Positionskarte auf das Modell-Layout dient. Es wird also in dem Modell-Layout ein (virtuelles) Referenz-PV-Modul festgelegt (z.B. an der rechten oberen Ecke des Modell-Layouts) und das zugehörige tatsächliche PV-Modul in der tatsächlichen PV-Anlage (tatsächliches Referenz-PV-Modul in der rechten oberen Ecke des PV-Generators) identifiziert. Dann wird die Zuordnung des tatsächlichen Referenz-PV-Moduls auf das virtuelle Referenz-PV-Modul als Referenzpunkt für das Einrasten der Ist-Positionskarte auf das Modell-Layout verwendet. Die Identifizierung des zum virtuellen Referenz-PV-Moduls zugehörigen tatsächlichen Referenz-PV-Moduls kann manuell festgelegt werden, z.B. durch Umlegen eines entsprechenden Schalters an dem PV-Modul, Zuordnung über eine Bedieneinheit oder eine Softwarekomponente zum Modell-Layout oder Einsetzen eines Steckers durch den Monteur. Das Referenz-PV-Modul kann aber auch mit einer Einrichtung zur Absolutbestimmung des tatsächlichen Ortes, z.B. einem Satellitenempfänger (z.B. GPS oder Galileo) ausgestattet sein. Das Referenz-PV-Modul sendet dann über das Kommunikations-Netzwerk eine absolute Positionsinformation an die Kontrolleinrichtung, so dass die absolute Positionsinformation als Referenz- oder "Ankerpunkt" für die Bestimmung der absoluten Positionen der anderen PV-Module dient. In beiden Fällen "kennt" die PV-Anlage bzw. das Netzwerk die absolute reale Position des tatsächlichen Referenz-PV-Moduls. Die absolute Position der anderen PV-Module wird dann mittels der absoluten Position des Referenz-PV-Moduls und der gemessenen Abstandswerte zwischen den PV-Modulen im Netzwerk bestimmt.

Es ist zweckmäßig als die zumindest eine Leistungskenngröße jedes PV-Moduls den momentanen Status, die momentane Leistung, die momentane Spannung und/oder den momentanen Strom zu erfassen und über das Kommunikations-Netzwerk an die Kontrolleinrichtung zu übertragen und dort zentral auszuwerten.

Gemäß einer allgemeinen Ausbildung der Erfindung kann die Datenübertragung aber auch über ein selbstorganisierendes kabelgebundenes Kommunikations-Netzwerk erfolgen. Hierbei können Daten sogar über die Stromleitungen übermittelt werden. In diesem Fall prägt das Kommunikations-Netzwerk die Signale auf die Stromleitungen der PV-Module auf und leitet sie an die Kontrolleinrichtung weiter. Dieses Verfahren ist insbesondere dann vorteilhaft, wenn die PV-Module selbst mit einem Wechselrichter ausgestattet sind. In diesem Fall kann die Information über das Wechselstrom-Versorgungsnetz der PV-Anlage übertragen werden. Verwendbar sind Übertragungssysteme wie z.B. digitalSTROM oder PowerLine.

In weiter vorteilhafter Ausgestaltung der Erfindung können die PV-Module jeweils einen Sensor zur Erfassung zumindest einer Umweltkenngröße, z.B. Modultemperatur, Umgebungstemperatur, Sonneneinstrahlung, Windrichtung und/oder Windstärke etc. umfassen und die zumindest eine Umweltkenngröße zusätzlich zu der zumindest einen Leistungskenngröße über das Kommunikations-Netzwerk an die Kontrolleinrichtung übertragen. Somit kann, insbesondere in Verbindung mit der Ortsinformation des PV-Moduls, von dem die jeweiligen Daten stammen, eine detaillierte Überwachung und Wartung, ggf. sogar Steuerung der PV-Anlage vorgenommen werden.

Es ist weiter vorteilhaft, herstellerspezifische Daten über das Kommunikationsnetzwerk zu übertragen und dem jeweiligen PV-Modul zuzuordnen. Herstellerspezifische Daten sind z.B. Leistungsdaten, Modultyp, ggf. Identifikationnummer, Seriennummer, Versionsnummer etc. Diese herstellerspezifischen Daten werden von der Kontrolleinrichtung, welche typischerweise durch einen Zentralrechner realisiert ist, den Soll-PV-Modulpositionen in dem Modell-Layout zugeordnet.

Mit der Erfindung ist vorteilhafter Weise eine Leistungsoptimierung bis auf PV-Modulebene möglich. Ferner kann eine genaue Wartungs- und Reparaturplanung durchgeführt werden, die sogar verschiedene Modultypen unterstützt.

Es ist zweckmäßig, die Messeinrichtung mit einem Sensor zur Erfassung der zumindest einen Leistungskenngröße und/oder die Kommunikationsschnittstelle unmittelbar in der Anschluss- und Verbindungsdose für die Außenanschlüsse, die sogenannten Ribbons, an der Rückseite des jeweiligen PV-Moduls zu integrieren, so dass keine zusätzlichen externen Bauteile an den PV-Modulen angebracht werden müssen. Vorzugsweise werden der Netzwerkkoordinator und die Kontrolleinrichtung in dem PV-Generator-Anschlusskasten des PV-Generators integriert.

Gemäß einer bevorzugten Ausführungsform der Erfindung wird als die zumindest eine Leistungskenngröße die momentane Spannung des PV-Moduls ohne Referenzspannung mittels eines nichtlinearen Effekts erfasst. Dies kann z.B. durch einen Kondensator, z.B. ebenfalls in der Anschluss- und Verbindungsdose, mit feldstärkenabhängiger Kapazität erfolgen, bei dem die Kapazität ein Maß für die momentane Spannung ist. Der Kondensator kann dann den Teil eines Schwingkreises bilden und es wird die Resonanzfrequenz des Schwingkreises als Maß für die PV-Modulspannung jedes PV-Moduls bestimmt. Zweckmäßig wird die Messeinrichtung zur Erfassung der zumindest einen Leistungskenngröße und/oder die Netzwerkschnittstelle der PV-Module unmittelbar von dem jeweiligen PV-Modul mit Energie versorgt (d.h. mit der von dem jeweiligen PV-Modul photovoltaisch erzeugten Solarenergie). Dadurch kann in vorteilhafter Weise eine zusätzliche Energieversorgung für die Messeinrichtung zur Erfassung der zumindest einen Leistungskenngröße und/oder die Netzwerkschnittstelle entfallen. Um bei einem Ausfall des PV-Moduls die Daten-Kommunikation über das Kommunikations-Netzwerk noch für eine gewisse Zeit weiter aufrecht zu erhalten, weisen die PV-Module vorzugsweise einen Energiespeicher, z.B. einen aufladbaren Batteriepuffer auf, der von dem jeweiligen PV-Modul geladen wird und der zumindest zur Versorgung der Netzwerkschnittstelle, ggf. noch zur Versorgung der Messeinrichtung zur Erfassung der zumindest einen Leistungskenngröße in dem jeweiligen PV-Modul dient. Dadurch ist zu jeder Zeit auch bei fehlender Sonneneinstrahlung, z.B. nachts eine Überwachung der PV-Module möglich. Insbesondere können die PV Module hierzu regelmäßig die Leistungskenngröße etc. über das Netzwerk melden. Alternativ kann die Versorgung auch über eine Rückspeisung aus der Leistungsverdrahtung erfolgen.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine herkömmliche PV-Anlage mit Ein-PV-Stromversorgungssystem gemäß DIN VDE 0100-712 (VDE 0100-712): 2006-06,
- Fig. 2: eine herkömmliche PV-Anlage mit mehreren PV-Teilgeneratoren gemäß DIN VDE 0100-712 (VDE 0100-712): 2006-06,
- Fig. 3: eine beispielhafte Architektur einer PV-Anlage mit einer Leistung von 2,5 MW_{P},
- Fig. 4: eine Vielzahl von PV-Modulen, die über ein vermaschtes Netzwerk miteinander verbunden sind,
- Fig. 5: die PV-Module aus Fig. 4 mit aus den Funksignalen ermittelten PV-Modulpositionen,
- Fig. 6: wie Fig. 5 mit Zuordnung der PV-Module nach Abgleich mit dem Modell-Layout der PV-Anlage,
- Fig. 7: schematische Darstellung eines Datentelegramms zur Übermittlung der zumindest einen erfassten Leistungskenngröße an den Netzwerkkoordinator und
- Fig. 8: eine Vorrichtung zur Messung der PV-Müdulspannung durch einen feldstärkenabhängigen Kondensator.

### Detaillierte Beschreibung der Erfindung

Bezug nehmend auf **Fig. 1** weist die PV-Anlage 1 eine Vielzahl von PV-Modulen 12 auf, von denen zunächst mehrere PV-Module 12 zu PV-Strängen 22 in Reihe geschaltet sind. Die PV-Module 12 umfassen jeweils eine auf der Rückseite befestigte Anschluss- und Verbindungsdose (nicht dargestellt) mit Anschlussklemmen für die elektrische Stromverkabelung und weisen optional jeweils eine Bypassdiode 14, typischerweise in der Anschluss- und Verbindungsdose, auf. Die PV-Stränge 22 sind über PV-Strangleitungen 24 parallel geschaltet und weisen gegebenefalls Überstromschutzeinrichtungen 26 und Sperrdioden 28 auf. Somit bilden die in diesem Beispiel seriell und parallel zusammengeschalteten PV-Module 12 einen PV-Generator 32. Die zusammengeschalteten PV-Module 12 liefern ihre elektrische Leistung über eine PV-Gleichstromleitung und eine Trenneinrichtung 36 an einen PV-Wechselrichter 42, welcher die von den PV-Modulen erzeugte Gleichspannung in eine netztaugliche Wechselspannung umrichtet. Der PV-Wechselrichter 42 ist in einem Gehäuse der sogenannten Schaltgerätekombination 48 eingebaut. Ein optionaler Transformator 44 in der Schaltgerätekombination 48 transformiert die Spannung je nach dem einzuspeisenden Stromnetz, so dass die PV-Anlage an das öffentliche Stromnetz gekoppelt werden kann. Mit der gleichstrom-seitigen Trenneinrichtung 36 und einer wechselstromseitigen Trenneinrichtung 46 kann der PV-Wechselrichter 42 z. B. für Wartungsmaßnahmen von spannungsführenden Teilen getrennt werden. Dem PV-Generator 32 ist ein PV-Generator-Anschluss-kasten 38 zugeordnet, in dem optionale Sperrdioden 28 sowie die Parallelschaltungspunkte 30 der PV-Stränge 22 angeordnet sind.

**Fig. 2** zeigt eine PV-Anlage 1', ähnlich wie in **Fig. 1****,** wobei aber mehrere PV-Teilgeneratoren 31 zu einem PV-Generator 32' zusammengeschaltet sind. Auch hier sind eine Mehrzahl von PV-Modulen 12 in jedem PV-Teilgenerator 31 zu PV-Strängen 22 in Reihe geschaltet. Jedem PV-Teilgenerator 31 ist ein PV-Teilgenerator-Anschlusskasten 37 zugeordnet in dem die PV-Stränge 22 an Parallelschaltpunkten 30 parallel zusammengeschaltet sind. Die PV-Teilgenerator-Anschlusskästen 37 sind über PV-Teilgenerator-Stromleitungen 52 mit einem PV-Generator-Anschlusskasten 38' vebunden, in dem wiederum die PV-Teilgeneratoren 31 zusammengeschaltet sind. Der PV-Generator-Anschlusskasten 38' ist über die PV-Gleichstromhauptleitung 34' mit dem PV-Wechselrichter 42 in dem Gehäuse der Schaltgerätekombination verbunden. Im Übrigen ist die PV-Anlage 1' ähnlich ausgebildet wie die PV-Anlage 1. Der grundsätzliche Aufbau solcher PV-Anlagen 1, 1' ist dem Fachmann bekannt und liegt den PV-Anlagen der vorliegenden Erfindung zugrunde.

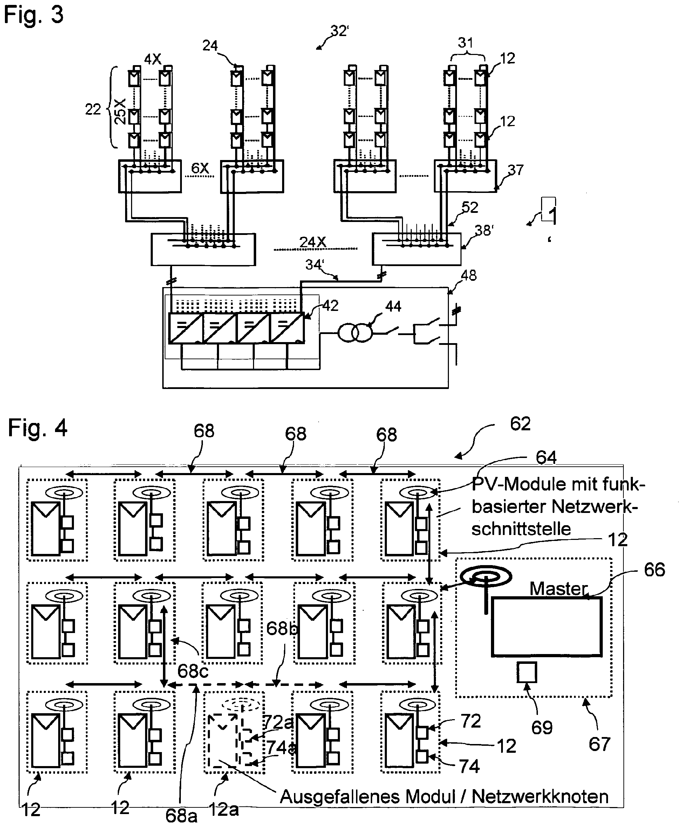

**Fig. 3** zeigt eine beispielhafte Architektur einer PV-Anlage 1' mit mehreren PV-Teilgeneratoren gemäß **Fig. 2** mit einer Leistung von 2,88 MWₚ. In der Figur 3 sind die PV-Module 12, die PV-Stränge 22, die PV-Teilgenerator-Anschlusskästen 37 und PV-Generator-Anschlusskästen 38' lediglich ausschnittsweise dargestellt. Die hier beispielhaft dargestellten PV-Module 12 sollen eine Nennleistung von 200 W_{P}, eine MPP-Spannung (@STC) von 25 V und einen MPP-Strom (@STC) von 8 A aufweisen. In jedem PV-Modul 12 ist eine entsprechende Anzahl von photovoltaischen Solarzellen zusammengeschaltet, um die angegebenen Leistungsdaten zu erreichen.

Die Architektur von PV-Anlagen 1' in diesem Beispiel umfasst 14.400 PV-Module 12, wobei jeweils 25 PV-Module pro PV-Strang (gleiche Anzahl Module für jeden Strang) in Serie geschaltet sind, so dass jeder Strang eine DC-Strang-Nennspannung von 625 V besitzt. Die PV-Module 12 sind ununterscheidbar bzw. nicht individualisiert oder identifiziert. Ferner sind hier 4 PV-Stränge 22 je PV-Teilgenerator 31 in einem Teilgenerator-Anschlusskästen 37 zusammengefasst und hiervon wiederum 6 in einem PV-Generator-Anschlusskasten 38'verbunden und zusammengeschaltet. Die 24 PV-Generator-Anschlusskästen 38' sind über eine gemeinsame DC-Schiene an einen oder mehrere PV-Zentralwechselrichter 42, beispielsweise in einem PV-Container 48 untergebracht, angeschlossen. Die PV-Wechselrichter in einem Leistungsbereich bis zu 1000 kVA können beispielsweise in dynamischer Master-Slave-Slave-Slave-(MSSS)-Konfiguration geschaltet sein. Bei großen PV-Kraftwerken wird die PV-Wechselspannung mit dem Transformator 44 auf das 20kV Niveau eines Mittelspannungsnetzes transformiert.

Erfindungsgemäß werden nun die PV-Module der PV-Anlage 1, 1' untereinander in einem Netzwerk 62 verbunden bzw. vernetzt. Das Netzwerk 62 kann funk- oder kabelgebunden sein und ist als ein selbstorganisierendes Netzwerk ausgebildet, wobei Ausfälle einzelner Netzwerkknoten 64 automatisch von dem selbstorganisierenden Netzwerk 62 kompensiert werden. Bezug nehmend auf **Fig. 4** sind beispielhaft 15 PV-Module 12 zu einem vermaschten selbstorganisierenden Netzwerk 62 verbunden. Vorteilhaft an einem vermaschten Netzwerk 62 ist, dass die Reichweite der einzelnen Funkstrecken relativ kurz sein kann, unabhängig davon, wie groß die PV-Anlage 1, 1' ist. Das Netzwerk 62 umfasst ferner eine Kontrolleinrichtung 67 mit einem Netzwerkkoordinator 66, der die über das Kommunikationsnetzwerk 62 übermittelten Daten für die weitere Bearbeitung und Auswertung bereitstellt und einen Datenspeicher 69. Jedes PV-Modul 12 umfasst eine in diesem Beispiel funkbasierte Netzwerkschnittstelle 72 und eine Messeinrichtung 74 zur Erfassung von Leistungskenngrößen wie z. B. Status, Leistung, Spannung, Strom. Die mit der Messeinrichtung 74 erfassten Leistungskenngrößen werden über das Kommunikationsnetzwerk 62 an den Netzwerkkoordinator 66 übertragen. Es ist ersichtlich, dass bei dem hier beispielhaft dargestellten Funknetzwerk 62 die Netzwerkverbindungen 68 zur Übertragung der Kommunikationsdaten unabhängig von den PV-Stromleitungen 24, 34, 34', 52 ist. Dies hat den Vorteil, dass die Stromverkabelung 24, 34, 34', 52 der PV-Anlage nach einer für die photovoltaische Leistungs-bereitstellung optimierte Architektur aufgebaut und verschaltet werden kann, ohne Rücksicht auf das Kommunikationsnetzwerk nehmen zu müssen. Selbst bei Verwendung eines kabelgebundenen Kommunikationsnetzwerks 62 können die Netzwerkleitungen unabhängig von der Stromverkabelung verlegt werden, wobei bei einem selbstorganisierenden Netzwerk 62 keine vorgegebene Vernetzungsstruktur eingehalten werden muss, was jedoch auch nicht prinzipiell ausgeschlossen ist. Wieder Bezug nehmend auf **Fig. 4** organisiert sich das Kommunikationsnetzwerk 62 mit Kommunikationsverbindungen 68 zwischen den einzelnen PV-Modulen zunächst selbstständig und bildet hierbei die Kommunikationsverbindungen 68 aus. Wenn wie in dem in **Fig. 4** dargestellten Beispiel ein bestimmtes PV-Modul 12a oder dessen Netzwerkschnittstelle 72a ausfällt, werden die mit diesem ausgefallenen Netzwerkmodul 12a verbundenen Netzwerkverbindungen 68a, 68b automatisch durch andere Netzwerkverbindungen, in diesem Beispiel 68c, kompensiert.

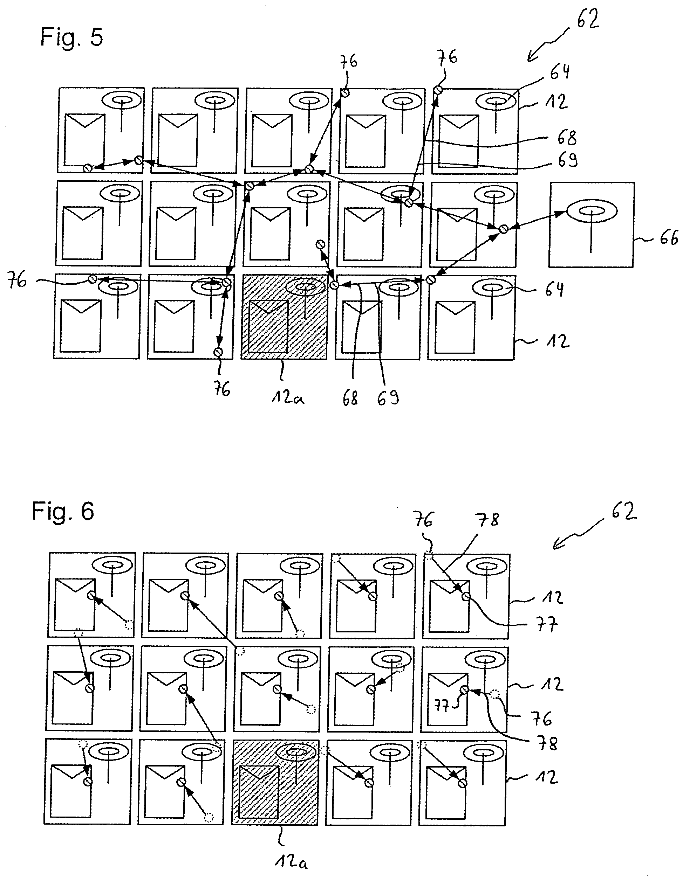

Bezug nehmend auf **Fig. 5** repräsentieren die Pfeile 69 die Entfernungsmessung mittels der Kommunikationsverbindungen, so dass in **Fig. 5** die Punkte 76 die gemessenen Positionen der PV-Module 12 repräsentieren. Bezug nehmend auf **Fig. 6** werden mit dem genannten Zuordnungsalgorithmus die gemessenen Positionen 76 den Soll-Positionen 77 in dem Modell-Layout der PV-Anlage 1, 1' zugeordnet, was durch die Pfeile 78 symbolisiert ist.

Bei dieser Ausführungsform des Netzwerks werden also die Signale der Messeinrichtungen 74 über die Funkverbindungen 68 dahingehend ausgewertet, dass eine Entfernungsbestimmung der PV-Module 12 zueinander durchgeführt wird. Bevorzugt ist der Netzwerkkoordinator 66 des Netzwerks hierbei in den PV-Teilgenerator-Anschlußkasten 37 (bei einer PV-Anlage gemäß Fig. 1 im PV-Generator-Anschlusskasten 38) integriert und hat eine freie Funkstrecke 68 zu mehr als einem, mindestens zwei PV-Modulen 12. Die Messergebnisse werden dann mit dem in dem Speicher 69 der Kontrolleinrichtung 67 hinterlegten mechanischen Modell-Layout der PV-Anlage 1, 1' verglichen, so dass die Messsignale und in Frage kommende Positionen abgeglichen und definiert zugeordnet werden können (sog. "einrasten" der gemessenen Positionen mit den Modell-Positionen). So werden bei Meßungenauigkeiten durch Störungen oder Hindernisse in einer oder einigen Funkstrecken 68 trotzdem eindeutige Zuordnungen ermöglicht. Hierfür sind zum Beispiel Algorithmen der Fehlerquadratminimierung anwendbar. Nicht durch Rückmeldungen "gefüllte" Positionen 12a in diesem Modell lassen auf einen Totalausfall oder Abhandensein des dort hingehörenden PV-Moduls 12a schliessen. Erfindungsgemäß kann daher beides, der Betriebszustand und das Vorhandensein jeweils modulspezifisch überwacht werden.

In vorteilhafter Weise kann mittels des Kommunikationsnetzwerks 62 und dem Soll- oder Modell-Layout der PV-Anlage somit ermittelt werden, an welcher Stelle in der PV-Anlage, welche wie vorstehend gezeigt, gegebenenfalls zehntausende von PV-Modulen enthalten kann, ausgefallen ist. Dies erleichtert ersichtlich die Wartung der PV-Anlage.

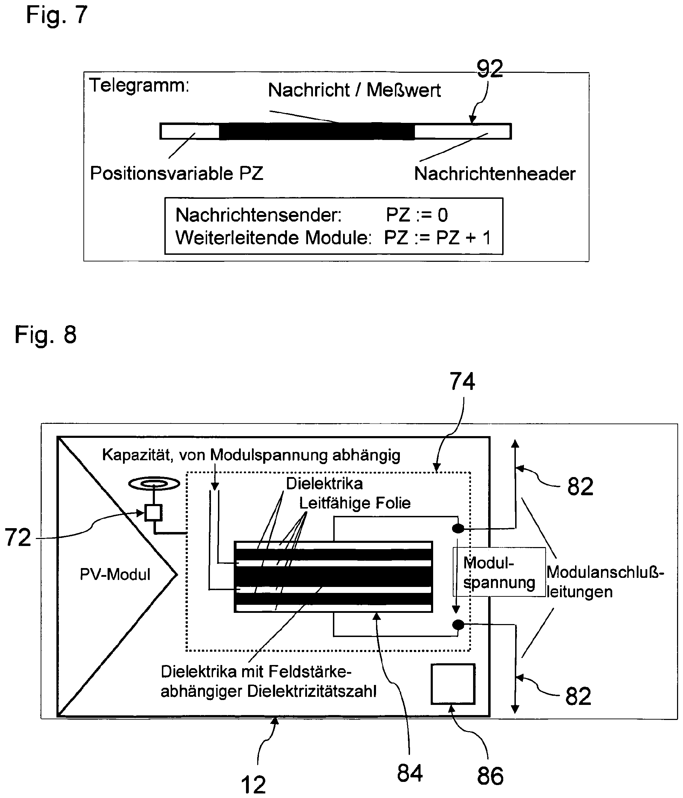

In einem kabelgebundenen Kommunikations-Netzwerk 62 ist eine Ortung der PV-Module 12 z.B. dadurch möglich, dass im Kommunikationsprotokoll ein Platzhalter (Zähler) vorgesehen ist, der durch jeden Netzwerkknoten 12 modifiziert werden kann, den das Nachrichtenpaket mit passiert, ohne die eigentliche Nachricht zu verändern. Bezug nehmend auf **Fig. 7** wird die Nachricht z.B. in einem Telegramm 92 mit einer Positionsvariablen PZ, einer Nachricht, die den Meßwert der zumindest einen Leistungskenngröße enthält und ggf. einem Nachrichtenheader übermittelt. Die Positionsvariable PZ ist z.B. ein Zähler, der mit jedem passierten Netzwerkknoten 64 um einen Wert (PZ + 1) erhöht wird. Dieses kann zum Beispiel in einem Netzwerk geschehen, bei der ein Netzwerkkoordinator im String-Combiner integriert ist und so das sendende PV-Modul 12 in der Form "n-tes Modul im Netzwerk" ortet und mit der Verkabelung des Solargenerators vergleicht, ohne dass es einer benutzgesteuerten Initialisierung bedarf. Ggf. ist auch die Ausweitung von zur Verfügung stehenden Signalen, z.B. GPS oder lokal implementierte Funksender, für die Lokalisierung der PV-Module möglich.

In einem einfachen Fall erfolgt nur die Erfassung eines einfachen Wertes, z.B. "in Ordnung" oder "nicht in Ordnung" bzw. "PV-Modul vorhanden" oder "PV-Modul nicht vorhanden". In einer erweiterten Ausführung kann eine Leistungsmessung und Übertragung der Leistungsdaten jedes PV-Moduls 12 erfolgen. In einer PV-Anlage 1, 1' mit einzelnen PV-Strängen 22 wird die zwischen den beiden aus jedem PV-Modul 12 herausgeführten Anschlußleitungen anliegenden Klemmenspannung gemessen.

Die Messwerte werden an die Kontrolleinrichtung 67 übertragen. In einer bevorzugten Ausführung ist diese in der PV-Array-Box 37 integriert. Die Messung des momentanen PV-Modul-Stromes kann in der PV-Array Box 37 zentral für alle PV-Module 12 der zugehörigen PV-Stränge 22 erfolgen. Die Leistung der einzelnen PV-Module 12 wird in der PV-Array Box 37 durch die integrierte Kontrolleinheit 67 ermittelt und gegebenenfalls weiter übermittelt. Durch einen Vergleich der PV-Strang-Spannung und der von allen PV-Modulen 12 des jeweiligen PV-Strangs 22 aufsummierten Einzelspannungen können so zusätzliche Spannungsabfälle an Verbindungs-Steckern bzw. -leitungen erfasst werden.

Bezug nehmend auf **Fig. 8** ist ein PV-Modul 12 dargestellt, welches an äußeren Modulanschlussleitungen 82, den so genannten "Ribbons" die Modulgleichspannung bereitsstellt. Nun wird z. B. in jedem PV-Modul 12 eine Messeinrichtung 74 mit einem Kondensator 84 zur Erfassung der Leistungskenngröße parallel zu den Modulanschlussleitungen geschaltet. Vorzugsweise wird das Überwachungssystem mit der Messeinrichtung 74 bzw. dem Kondensator 84 sowie die Netzwerkschnittstelle 72 jedes PV-Moduls 12 in die zugehörige auf dem jeweiligen PV-Modul 12 befestigte Anschluss- und Verbindungsdose (vgl. z. B. DE 10 2007 037 130 und DE 10 2007 042 547 der gleichen Anmelderin) integriert. Vorzugsweise wird die Messeinrichtung zur Erfassung der zumindest einen Leistungskenngröße und/oder die Netzwerkschnittstelle von der photovoltaisch erzeugten elektrischen Energie des jeweils zugehörigen PV-Moduls gespeist. Hierzu können die Messeinrichtung zur Erfassung der zumindest einen Leistungskenngröße und/oder die Netzwerkschnittstelle an die Kontakteinrichtung zur Kontaktierung der Ribbons in der Anschluss- und Verbindungsdose angeschlossen werden (vgl. z. B. DE 10 2007 037 130 und DE 10 2007 042 547 der gleichen Anmelderin).

Mit der in **Fig. 8** dargestellten Ausführungsform erfolgt die Messung der Spannung ohne Referenzspannung durch Ausnutzung nichtlinearer Effekte in dem elektrischen Feld, welches durch die Modulspannung erzeugt wird. So wird mit einem Material, dessen Dielektrizitätszahl von der elektrischen Feldstärke abhängt, eine von der Modulspannung abhängige Kapazität des Kondensators 84 realisiert. Diese Kapazität beziehungsweise deren Änderung in Abhängigkeit von der Modulspannung kann dann ausgewertet werden, zum Beispiel durch die sich in einem mit dieser Kapazität realisierten Schwingkreis ausbildende / verschobene Resonanzfrequenz oder die Entladezeit über einen Widerstand. Das erfolgt zum Beispiel durch Abgleich mit einer bekannten Frequenz (z.B. der Funkfrequenz im Netzwerk oder einem integrierten Quarz). Der Kondensator 84 kann dabei sowohl Teil des DC-Kreises sein in die mittels HF-Übertrager eingekoppelt wird, als auch galvanisch getrennt sein, das Dielektrikum wird dann nur vom jeweiligen vom Modul erzeugten E-Feld durchsetzt.

Das Meßergebnis wird über ein Netzwerk an einen lokalen Netzwerkkoordinator übertragen, dieses geschieht entweder zyklisch als Datenpaar Adresse und Spannungswert oder azyklisch nach Aufforderung durch den Netzwerkkoordinator.

Die Energieversorgung der Messeinrichtungen 74 bzw. Sensoren kann über das PV-Modul 12 erfolgen. Jeweils ein optionaler Energiespeicher 86 an den PV-Modulen 12, der durch das jeweilige PV-Modul 12 geladen wird kann auch dann noch kurzzeitig Messungen durchführen und Nachrichten z.B. an den Netzwerkkoordinator 66 senden, wenn die PV-Modulleistung abnimmt. Der Netzwerkkoordinator beurteilt die Situation und leitet gegebenenfalls Handlungsmaßnahmen ein (Bsp: Ein Modul meldet Leistungsabfall, alle anderen Funktionieren normal: Dämmerung oder Bewölkung kann ausgeschlossen werden). In diesem Fall meldet der Netzwerkkoordinator 66 eine Störung dieses PV-Moduls.

Alternativ kann die Energieversorgung über das Funksignal erfolgen. Dieses ist ausreichend, um den Sensor zu starten, die Messung durchzuführen und den Meßwert zum Netzwerkkoordinator 66 zurückzusenden. Aus dem Stand der Technik sind weitere Möglichkeiten zur autarken Energieversorgung unter dem Stichwort "Energy Harvesting" bekannt, die in diesem Fall auch zur Anwendung kommen können, beispielsweise durch Ausnutzung des thermoelektrischen Effektes.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne die Erfindung zu verlassen; der Umfang der Erfindung wird in den Ansprüchen definiert.

## Patentansprüche

1. Photovoltaik-(PV)-Anlage umfassend:
eine Vielzahl von PV-Modulen (12),
Stromverbindungsleitungen (24) mittels welchen die PV-Module (12) seriell und/oder parallel zu einem PV-Generator (32, 32') zusammengeschaltet sind und über welche der von den PV-Modulen (12) erzeugte elektrische Strom geleitet wird,
einen oder mehrere PV-Wechselrichter (42) zur Umwandlung des von den PV-Modulen (12) erzeugten Gleichstroms in einen netztauglichen Wechselstrom,
wobei die PV-Module (12) jeweils eine Kommunikations-Schnittstelle (72) aufweisen und zu einem Kommunikations-Netzwerk (62) miteinander verbunden sind, so dass die einzelnen PV-Module (12) Netzknoten des Kommunikations-Netzwerkes (62) bilden,
wobei über das Kommunikations-Netzwerk (62) von den PV-Modulen (12) Kommunikations-Nachrichten mit modulspezifischen Daten an eine Kontrolleinrichtung (67) übertragen werden, so dass die Kontrolleinrichtung (67) die modulspezifischen Daten dem jeweiligen PV-Modul zuordnen kann,
wobei das Kommunikations-Netzwerk (62) als ein selbstorganisierendes Netzwerk ausgebildet ist, bei welchem sich die PV-Module (12) selbstständig untereinander vernetzen,
wobei das Kommunikations-Netzwerk (62) unabhängig von den Stromverbindungsleitungen (24) für die photovoltaisch erzeugte Leistung ist und sich die Topologie des Kommunikations-Netzwerks (62) von der Topologie der Stromverbindungsleitungen (24) unterscheidet.

2. PV-Anlage nach Anspruch 1,
wobei die PV-Module (12) jeweils eine Messeinrichtung (74) zur Erfassung von zumindest einer Leistungskenngröße aufweisen, so dass die Leistungskenngröße individuell je PV-Modul (12) erfasst werden kann, und die zumindest eine erfasste Leistungskenngröße des jeweiligen PV-Moduls (12) über das Kommunikations-Netzwerk an die Kontrolleinrichtung (67) übertragen wird, so dass die Kontrolleinrichtung (67) die zumindest eine Leistungskenngröße modulspezifisch auswerten kann.

3. PV-Anlage nach Anspruch 1 oder 2,
wobei sich das Kommunikations-Netzwerk (62) den Ausfall eines Netzknotens automatisch kompensiert.

4. PV-Anlage nach Anspruch 1, 2 oder 3,
wobei die Netzwerk-Adresse der PV-Module (12) in selbstorganisierender Form von dem Kommunikations-Netzwerk (62) vergeben wird.

5. PV-Anlage nach einem der vorstehenden Ansprüche, wobei das selbstorganisierende Netzwerk (62) als ein vermaschtes Netzwerk ausgebildet ist.

6. PV-Anlage nach Anspruch 5,
wobei das selbstorganisierende Netzwerk (62) als ein vermaschtes Funk-Netzwerk ausgebildet ist.

7. PV-Anlage nach Anspruch 6,
wobei das vermaschte Funk-Netzwerk (62) Mittel zur Entfernungsmessung zwischen den Netzknoten oder zwischen den Netzknoten und zwischen zumindest einem der Netzknoten und einem fest vorgegebenen Bezugspunkt aufweist, so dass jeweils die tatsächliche Entfernung zwischen den Netzknoten messbar ist und die Entfernungsdaten über das Funk-Netzwerk (62) an die Kontrolleinrichtung (67) übermittelt werden.

8. PV-Anlage nach einem der vorstehenden Ansprüche, wobei mittels der empfangenen Entfernungsdaten eine Ist-Positionskarte (Fig. 5) der tatsächlichen PV-Module (12) in dem Netzwerk (62) mit den in selbstorganisierender Form vergebenen Adressen der jeweiligen PV-Module (12) erstellt wird und die modulspezifischen Daten, insbesondere die zumindest eine erfasste Leistungskenngröße des jeweiligen PV-Moduls (12), zur ermittelten Ist-Position (76) des jeweiligen PV-Moduls (12) zugeordnet werden, so dass eine örtliche Zuordnung der modulspezifischen Daten, insbesondere der zumindest einen Leistungskenngröße für jedes PV-Modul (12), in dem PV-Generator (32, 32') ermöglicht ist.

9. PV-Anlage nach einem der vorstehenden Ansprüche, wobei ein Speicher (69) mit einem gespeicherten Modell-Layout der örtlichen Soll-Positionen der PV-Module (12) in dem PV-Generator (32, 32') umfasst ist, wobei eine Ist-Positionskarte der tatsächlichen Positionen der PV-Module (12) ermittelt wird und die Ist-Positionskarte mit dem Modell-Layout abgeglichen wird und wobei die modulspezifischen Daten, insbesondere die zumindest eine jeweils erfasste Leistungskenngröße der tatsächlichen PV-Module (12) jeweils einer PV-Modulposition in dem Modell-Layout zugeordnet werden.

10. PV-Anlage nach einem der vorstehenden Ansprüche, wobei zumindest eines der PV-Module als Referenz-PV-Modul ausgebildet ist, wobei die tatsächliche absolute Position des Referenz-PV-Moduls von der Kontrolleinrichtung (67) abrufbar ist, und als Referenzpunkt zur Positionsbestimmung der übrigen PV-Module (12) verwendet wird.

11. PV-Anlage nach einem der vorstehenden Ansprüche, wobei die zumindest eine Leistungskenngröße der momentane Status, die momentane Leistung, die momentane Spannung oder der momentane Strom des jeweiligen PV-Moduls (12) ist.

12. PV-Anlage nach einem der vorstehenden Ansprüche, wobei eine Schadenserkennungseinrichtung umfasst ist, welche aus der Summe der Modulleistungen je Strang oder in der gesamten Anlage und einem Abgleich mit den an einem oder mehreren Invertern anliegenden DC-Leistung Schäden in der Leistungsverkabelung oder Fehler bei der Installation der Leistungsverkabelung erkennt.

13. PV-Anlage nach einem der vorstehenden Ansprüche, wobei die PV-Module (12) jeweils einen Sensor zur Erfassung zumindest einer Umweltkenngröße, insbesondere Modultemperatur, Umgebungstemperatur, Sonneneinstrahlung, Windrichtung oder Windstärke, umfassen und die zumindest eine Umweltkenngröße zusätzlich zu der zumindest einen Leistungskenngröße über das Kommunikations-Netzwerk an die Kontrolleinrichtung (67) übertragen wird.

14. PV-Anlage nach einem der vorstehenden Ansprüche, wobei die Messeinrichtung (74) für die zumindest eine Leistungskenngröße und/oder die Kommunikationsschnittstelle (72) in der Anschluss- und Verbindungsdose für die Außenanschlüsse an der Rückseite des zugehörigen PV-Moduls (12) integriert sind.

15. PV-Anlage nach einem der vorstehenden Ansprüche, wobei der Netzwerkkoordinator (66) des Kommunikations-Netzwerks (62) in dem PV-Generator-Anschlusskasten (38, 38') oder PV-Teilgenerator-Anschlusskasten (37) des PV-Generators (32, 32') integriert ist.

16. PV-Anlage nach einem der vorstehenden Ansprüche, wobei die zumindest eine Leistungskenngröße die momentane Spannung des PV-Moduls (12) ist und die momentane Spannung ohne Referenzspannung mittels eines nichtlinearen Effekts erfasst wird.

17. PV-Anlage nach Anspruch 16,
wobei die Messeinrichtung (74) zur Erfassung der momentanen Spannung einen Kondensator (84) mit feldstärkenabhängiger Kapazität umfasst, so dass Kapazität des Kondensators (84) ein Maß für die momentane Spannung ist.

18. PV-Anlage nach Anspruch 17,
wobei der Kondensator (84) Teil eines Schwingkreises ist und die Resonanzfrequenz des Schwingkreises bestimmt wird.

19. PV-Anlage nach einem der vorstehenden Ansprüche, wobei die Messeinrichtung (74) zur Erfassung der zumindest einen Leistungskenngröße und/oder die Netzwerkschnittstelle (72) unmittelbar von dem zugehörigen PV-Modul (12) mit von diesem PV-Modul (12) photovoltaisch erzeugter Energie versorgt wird.

20. PV-Anlage nach einem der vorstehenden Ansprüche, wobei die PV-Module (12) jeweils einen Energiespeicher (86) aufweisen, welcher bei einem Ausfall des PV-Moduls (12) die Daten-Kommunikation über das Kommunikations-Netzwerk (62) noch zumindest für eine gewisse Zeit weiter ermöglicht.

## Claims

1. A photovoltaic (PV) system, comprising:
a multitude of PV modules (12);
power connection lines (24) by which the PV modules (12) are connected in series and/or in parallel with a PV generator (32, 32') and through which the electric current generated by the PV modules (12) is conducted;
one or more PV inverters (42) for converting the direct current generated by the PV modules (12) into a power grid-compatible alternating current;
wherein the PV modules (12) each have a communication interface (72) and are interconnected to form a communication network (62) so that the individual PV modules (12) form network nodes of the communication network (62);
wherein the PV modules (12) transmit communication messages with module-specific data via the communication network (62) to a control device (67), so that the control device (67) can associate the module-specific data with the respective PV module;
wherein the communication network (62) is configured as a self-organizing network in which the PV modules (12) autonomously network among each other;
wherein the communication network (62) is independent of the power connection lines (24) for the photovoltaically generated power, and wherein the topology of the communication network (62) is different from the topology of the power connection lines (24).

2. The PV system according to claim 1,
wherein the PV modules (12) each have a measuring device (74) for capturing at least one performance parameter, so that the performance parameter can be captured individually for each PV module (12), and wherein the at least one captured performance parameter of the respective PV module (12) is transmitted to the control device (67) via the communication network, so that the control device (67) is able to evaluate the at least one performance parameter in a module-specific manner.

3. The PV system according to claim 1 or 2, wherein the communication network (62) automatically compensates for a failure of a network node.

4. The PV system according to claim 1, 2 or 3, wherein the network address of the PV modules (12) is assigned in self-organizing form by the communication network (62).

5. The PV system according to any one of the preceding claims, wherein the self-organizing network (62) is configured as a meshed network.

6. The PV system according to claim 5, wherein the self-organizing network (62) is configured as a meshed wireless network.

7. The PV system according to claim 6, wherein the meshed wireless network (62) comprises means for measuring the distance between the network nodes or between the network nodes and between at least one of the network nodes and a fixedly predefined reference point, so that the actual distance between the network nodes is measurable in each case, and wherein the distance data are transferred to the control device (67) via the wireless network (62).

8. The PV system according to any one of the preceding claims, wherein the received distance data are used to create an actual-position map (FIG. 5) of the actual PV modules (12) in the network (62) with the addresses of the respective PV modules assigned in self-organizing form, and wherein the module-specific data, in particular the at least one captured performance parameter of the respective PV module (12) are associated with the determined actual position (76) of the respective PV module (12), so that an association of the module-specific data, in particular of the at least one performance parameter, is possible in terms of location for each PV module (12) in the PV generator (32, 32').

9. The PV system according to any one of the preceding claims, wherein the PV generator (32, 32') comprises a memory (69) with a model layout of the local target positions of the PV modules (12) stored therein, wherein an actual-position map of the actual positions of the PV modules (12) is determined, and the actual-position map is compared with the model layout, and wherein the module-specific data, in particular the respective at least one captured performance parameter of the actual PV modules (12) are respectively associated with a PV module position in the model layout.

10. The PV system according to any one of the preceding claims, wherein at least one of the PV modules is configured as a reference PV module, wherein the actual absolute position of the reference PV module can be retrieved from the control device (67) and is used as a reference point for determining the position of the remaining PV modules (12).

11. The PV system according to any one of the preceding claims, wherein the at least one performance parameter is the current status, the current power, the current voltage, or the current amperage of the respective PV module (12).

12. The PV system according to any one of the preceding claims, wherein a defect detection device is incorporated which identifies defects in the power cabling or faults in the installation of the power cabling from the total of module power per string or of the entire system and a comparison with the DC power applied to one or more inverters.

13. The PV system according to any one of the preceding claims, wherein the PV modules (12) each comprise a sensor for capturing at least one environmental parameter, in particular module temperature, ambient temperature, solar irradiation, wind direction, or wind force, and wherein the at least one environmental parameter is transmitted to the control device (67) via the communication network in addition to the at least one performance parameter.

14. The PV system according to any one of the preceding claims, wherein the measuring device (74) for the at least one performance parameter and/or the communication interface (72) are integrated in the junction and connection box for the external connections at the rear face of the associated PV module (12).

15. The PV system according to any one of the preceding claims, wherein the network coordinator (66) of the communication network (62) is integrated in the PV generator junction box (38, 38') or the PV sub-generator junction box (37) of the PV generator (32, 32').

16. The PV system according to any one of the preceding claims, wherein the at least one performance parameter is the current voltage of the PV module (12), and wherein the current voltage is detected without reference voltage, through a non-linear effect.

17. The PV system according to claim 16, wherein the measuring device (74) for capturing the current voltage comprises a capacitor (84) with field strength dependent capacitance, so that the capacitance of the capacitor (84) is a measure of the current voltage.

18. The PV system according to claim 17, wherein the capacitor (84) is part of a resonant circuit and the resonance frequency of the resonant circuit is determined.

19. The PV system according to any one of the preceding claims, wherein the measuring device (74) for capturing the at least one performance parameter and/or the network interface (72) are directly powered by the associated PV module (12) with energy pnotovoltaically generated by this PV module (12).

20. The PV system according to any one of the preceding claims, wherein the PV modules (12) each have an energy storage (86) which in case of failure of the PV module (12) still allows data communication via the communication network (62) at least for a certain period of time.

## Revendications

1. Installation photovoltaïque (PV) comprenant :
une pluralité de modules PV (12),
des lignes de raccordement électrique (24) au moyen desquelles les modules PV (12) sont interconnectés en série et/ou en parallèle pour former un générateur PV (32, 32') et par l'intermédiaire desquelles le courant électrique généré par les modules PV (12) est conduit,
un ou plusieurs onduleurs PV (42) destinés à convertir le courant continu généré par les modules PV (12) en courant alternatif compatible avec le réseau,
les modules PV (12) présentant chacun une interface de communication (72) et étant reliés les uns aux autres pour former un réseau de communication (62), de sorte que les modules PV (12) individuels constituent des noeuds du réseau de communication (62),
sachant que des messages de communication comportant des données spécifiques de module sont transmis depuis les modules PV (12) à un dispositif de contrôle (67), via le réseau de communication (62), de sorte que le dispositif de contrôle (67) peut affecter au module PV concerné les données spécifiques de module,
le réseau de communication (62) étant conçu sous la forme d'un réseau auto-organisateur dans lequel les modules PV (12) s'interconnectent en réseau entre eux de façon autonome,
le réseau de communication (62) étant indépendant des lignes de raccordement électrique (24) pour la puissance produite par voie photovoltaïque, et la topologie du réseau de communication (62) étant différente de la topologie des lignes de raccordement électrique (24).

2. Installation PV selon la revendication I,
dans laquelle les modules PV (12) comportent chacun un dispositif de mesure (74) destiné à recueillir au moins une caractéristique de puissance, de sorte que la caractéristique de puissance peut être mesurée individuellement pour chaque module PV (12), et la caractéristique de puissance recueillie, au nombre d'au moins une, du module PV (12) respectif est transmise au dispositif de contrôle (67) via le réseau de communication, de sorte que le dispositif de contrôle (67) peut évaluer la caractéristique de puissance, au nombre d'au moins une, de manière spécifique au module.

3. Installation PV selon la revendication I ou 2,
dans laquelle le réseau de communication (62) compense automatiquement la défaillance d'un noeud de réseau.

4. Installation PV selon la revendication 1, 2 ou 3,
dans laquelle l'adresse réseau des modules PV (12) est attribuée sous une forme auto-organisée par le réseau de communication (62).

5. installation PV selon l'une des revendications précédentes,
dans laquelle le réseau auto-organisateur (62) est réalisé sous forme de réseau maillé.

6. Installation PV selon la revendication 5,
dans laquelle le réseau auto-organisateur (62) est réalisé sous forme de réseau radio maillé.

7. Installation PV selon la revendication 6,
dans laquelle le réseau radio maillé (62) comporte des moyens pour mesurer la distance entre les noeuds de réseau ou entre les noeuds de réseau et entre au moins l'un des noeuds de réseau et un point de référence prédéterminé de manière fixe, de sorte que l'on peut mesurer chaque fois la distance réelle entre les noeuds de réseau et que les données de distance sont transmises au dispositif de contrôle (67) par l'intermédiaire du réseau radio (62).

8. Installation PV selon l'une des revendications précédentes,
dans laquelle une carte de positions réelles (fig. 5) des modules PV (12) effectifs est créée au moyen des données de distance reçues, dans le réseau (62) avec les adresses des modules PV (12) respectifs affectées sous forme auto-organisée, et les données spécifiques de module, en particulier la caractéristique de puissance recueillie, au nombre d'au moins une, du module PV (12) respectif, sont associées à la position réelle (76) déterminée du module PV (12) respectif, de sorte qu'une affectation locale des données spécifiques de module, en particulier de la caractéristique de puissance, au nombre d'au moins une, pour chaque module PV (12), est rendue possible dans le générateur PV (32, 32').

9. Installation PV selon l'une des revendications précédentes,
dans laquelle une mémoire (69), avec une configuration de modèle enregistrée des positions de consigne locales des modules PV (12), est comprise dans le générateur PV (32, 32"), et dans laquelle une carte de positions réelles des positions effectives des modules PV (12) est déterminée et la carte de positions réelles est comparée avec la configuration du modèle, et dans laquelle les données spécifiques de module, en particulier la caractéristique de puissance respectivement détectée, au nombre d'au moins une, des modules PV (12) réels, sont respectivement affectées à une position de module PV dans la configuration du modèle.

10. Installation PV selon l'une des revendications précédentes,
dans laquelle au moins un des modules PV est conçu comme module PV de référence, et dans laquelle la position absolue réelle du module PV de référence peut être sélectionnée par le dispositif de contrôle (67) et est utilisée comme point de référence pour déterminer la position des autres modules PV(12).

11. Installation PV selon l'une des revendications précédentes,
dans laquelle la caractéristique de puissance, au nombre d'au moins une, est l'état instantané, la puissance instantanée, la tension instantanée ou le courant instantané du module PV (12) respectif.

12. Installation PV selon l'une des revendications précédentes,
dans laquelle il est prévu un dispositif de détection de détériorations qui détecte des détériorations dans le câblage de puissance ou des erreurs lors de l'installation du câblage de puissance, en se basant sur la somme des puissances de modules par branche ou dans l'ensemble de l'installation et sur une comparaison avec les puissances CC appliquées à un ou plusieurs onduleurs.

13. Installation PV selon l'une des revendications précédentes,
dans laquelle les modules PV (12) comportent chacun un capteur destiné à mesurer au moins une caractéristique environnementale, en particulier une température de module, la température ambiante, le rayonnement solaire, la direction ou la force du vent, et la caractéristique environnementale, au nombre d'au moins une, est transmise au dispositif de contrôle (67) via le réseau de communication, en plus de la caractéristique de puissance, au nombre d'au moins une.

14. Installation PV selon l'une des revendications précédentes,
dans laquelle le dispositif de mesure (74) pour la caractéristique de puissance, au nombre d'au moins une, et/ou l'interface de communication (72) sont intégrés dans le boîtier de raccordement et de connexion pour les connexions externes sur la face arrière du module PV (12) associé.

15. Installation PV selon l'une des revendications précédentes,
dans laquelle le coordinateur de réseau (66) du réseau de communication (62) est intégré dans le boîtier de raccordement de générateur PV (38, 38') ou le boîtier de raccordement de générateur partiel PV (37) du générateur PV (32, 32").

16. Installation PV selon l'une des revendications précédentes,
dans laquelle la caractéristique de puissance, au nombre d'au moins une, est la tension instantanée du module PV (12), et la tension instantanée est mesurée sans tension de référence, au moyen d'un effet non linéaire.

17. Installation PV selon la revendication 16,
dans laquelle le dispositif de mesure (74) comprend un condensateur (84) ayant une capacité qui est fonction de l'intensité de champ, afin de mesurer la tension instantanée, de sorte que la capacité du condensateur (84) constitue une mesure de la tension instantanée.

18. Installation PV selon la revendication 17,
dans laquelle le condensateur (84) fait partie d'un circuit résonant, et la fréquence de résonance du circuit résonant est déterminée.

19. Installation PV selon l'une des revendications précédentes,
dans laquelle le dispositif de mesure (74), destiné à mesurer la caractéristique de puissance, au nombre d'au moins une, et/ou l'interface réseau (72) sont alimentés directement par le module PV (12) associé, avec de l'énergie produite par voie photovoltaïque par ce module PV (12).

20. Installation PV selon l'une des revendications précédentes,
dans laquelle les modules PV (12) présentent chacun un accumulateur d'énergie (86) qui, en cas de défaillance du module PV (12), permet de poursuivre encore au moins pendant un certain temps la communication de données par l'intermédiaire du réseau de communication (62).
